(19) **Europäisches Patentamt European Patent Office Office européen des brevets**

(11) **EP 2 080 413 B1**

(12) **EUROPEAN PATENT SPECIFICATION**

(45) Date of publication and mention
of the grant of the patent:
**18.06.2014 Bulletin 2014/25**

(21) Application number: **07854168.7**

(22) Date of filing: **18.10.2007**

(51) Int Cl.:
**H05B 1/02** (2006.01)

(86) International application number:
**PCT/US2007/081784**

(87) International publication number:
**WO 2008/057735 (15.05.2008 Gazette 2008/20)**

(54) **SYSTEM AND METHOD FOR COMPENSATION OF PHASE HITS**

SYSTEM UND VERFAHREN ZUR KOMPENSATION VON PHASENSPITZEN

SYSTEME ET PROCEDE DE COMPENSATION DE BRUSQUES VARIATIONS DE PHASE

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **27.10.2006 US 588681**

(43) Date of publication of application:
**22.07.2009 Bulletin 2009/30**

(73) Proprietor: **Harris Stratex Networks Operating Corporation Morrisville, NC 27560 (US)**

(72) Inventors:
• **PHAM, David C., M.**
  **Fremont, CA 94539 (US)**

• **MATSUMOTO, Frank S.**
  **San Ramon, CA 94583 (US)**
• **QIN, Youming**
  **Sunnyvale, CA 94087 (US)**

(74) Representative: **Round, Edward Mark Marks & Clerk LLP 90 Long Acre London WC2E 9RA (GB)**

(56) References cited:
**US-A- 4 642 735       US-A1- 2002 119 797
US-A1- 2004 072 597   US-A1- 2004 162 042
US-A1- 2004 246 891   US-A1- 2005 030 108
US-B1- 6 501 340      US-B2- 6 630 869**

**Description**

TECHNICAL FIELD

This invention relates generally to wireless radio systems, and more particularly provides a system and method for compensation of phase hits in microwave and millimeter wave digital radios.

BACKGROUND

User demand for wireless communication is at record high. Currently, wireless systems are being implemented in cellular networks, fixed networks, private networks, etc and may employ point-to-point, point-to-multipoint, local multipoint distribution services, and mesh architectures, Such wireless network systems typically include nodes or terminals, each including an indoor unit (IDU) and an outdoor unit (ODU). The IDU typically includes a modern and a power supply. The ODU functions to transmit and receive data to and from a transceiver antenna, and typically includes a number of subassemblies. ODU subassemblies may include a power supply, frequency converters, a frequency synthesizer, a diplexer, and other circuits.

To manufacture an ODU, the various subassemblies are installed m a housing, and the ODU is then tested. Its operational characteristics based on temperature fluctuations are measured a process which often takes hours to complete, is expensive, requires manual labor, and results in low reliability. Armed with the operational characteristics based on temperature, the ODU and IDU can better interpret outgoing and incoming signals sent to and received from the transceiver antenna.

Since ODUs share the airwaves, the regulatory agencies have imposed limits on bandwidth and amplitude in various radio frequency bands Accordingly, designers of digital RF telecommunication systems are encouraged to transmit as much data as possible within the limits of the available bands. As a result, designers have developed a variety of modulation schemes. A few modulation schemes include amplitude modulation (where different amplitudes are used to represent information symbols or digital states), frequency modulation (where different frequencies are used to represent information symbols or digital states), and phase modulation (where a particular phase is used to represent the information symbols or digital states) Other more sophisticated and efficient modulation schemes include quadrature ampiltude modulation (QAM) and other coherent phase shift keying (PSK) and frequency shift keying (FSK) modulation schemes.

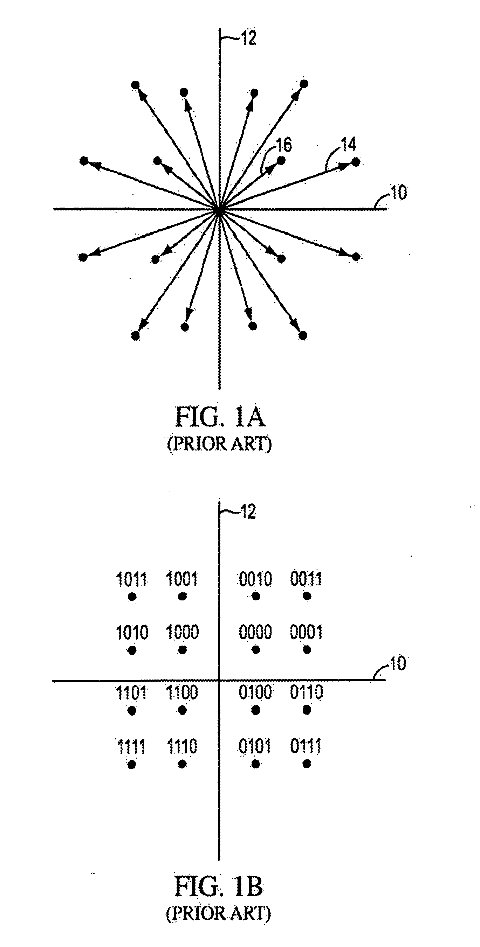

To encode digital data using QAM, the phase and amplitude of a carrier frequency are manipulated relative to a stable frequency, single amplitude reference source. Figure 1A shows a symbolie diagram of a circular QAM modulation scheme As shown, axes 10 and 12 divide the "constellation" of points or symbols into four quadrants. Each point is positioned about the constellation space in a rotated manner and represents a particular member of encoded information. That is, each character (such as encoded ASCII "A" symbol) is represented by a vector in the circular constellation space with the phase angle ot the carrier relative to the phase angle of the reference, and with the reference and carrier amplitude equal to the amplitude of the vector Thus for example, the vector 14 may represent the encoded ASCII "A" symbol, and the vector 16 may represent an encoded ASCII "B" symbol. As the number of points in the constellation increases, the amount or granularity of information communicated by a single point also increases. However, since the angle to distinguish between adjacent points decreases as the number of points increases, discrimination between different points becomes more difficult. Thus, error potential in the QAM modulation scheme also increases.

Figure 1B shows a symbolic diagram of a rectangular QAM modulation scheme. Like Figure 1A, the symbolic diagram of Figure 1B includes two axes 10 and 12 that divide the constellation of points or symbols into four quadrants. In this example, each point is positioned in a rectangular pattern and represents a set of bits where the number of bits represents the resolution of the QAM modulation or QAM level; and the bit values represent the reference values. For the 16-point QAM modulation scheme shown here, each point in the constellation space represents four (4) bits. As the number of points in the constellation space increase, the number of bits corresponding to a single point also increases. However, like circular QAM, as the number of points in the constellation increases, the error potential when discriminating between different points also increases.

Typical constellations in modern QAM modulation schemes may consist of 64, 128, 256 or higher number of points. The various QAM modulation schemes are represented with circular and/or rectangular constellations. For instance, a 64-QAM can tolerate phase errors of only about four (4) degrees before data errors occur. Constellations having 128 points or 256 points increase error potential even further. Accordingly, when implementing modulation schemes in a wireless radio system, such as a split-mount wireless radio with an IDU and ODU assembly, phase noise becomes a large problem. A phase error may lead to an incorrect interpretation of a point or a bit error. If an error burst exceeds the error correction capability of the receiver, then frame loss can happen and the frame must be retransmitted, thus wasting valuable bandwidth resources.

One type of typical phase disturbance is called a "phase hit." A phase hit is a sudden change in the phase of the local oscillator frequency, often caused by a sudden mechanical relief of stress and/or strain within the package of the oscillator during temperature changes, particularly cooling. A typical cause of phase hits is ambient temperature fluctuations. For example, rising and lowering temperatures can cause expansion and contraction of the physical subassemblies of the ODU, especially of the frequency synthesizer, which can cause changes in its frequency response.

Prior art techniques to minimize phase hits include careful selection of material and components with similar temperature expansion coefficients, and careful assembly of the subassemblies of the ODU. However, perfect matches in temperature coefficients of material and components and perfect assembly in manufacturing to match their behavior with temperature fluctuations cannot be guaranteed. Further, prior art techniques involving careful selection of critical components (such as the VCO) limit the number of vendors with the know-how and product quality. Further, even with specifically selected components, thermal testing still produces low manufacturing yield due to component imperfections. Accordingly, thermal testing must be repeated several times, which adds to product cost.

US 6501340 discloses apparatus and a method for stabilizing the frequency of a piezoelectric crystal resonator.

US 6630869 discloses a temperature stable voltage controlled oscilator.

Accordingly, systems and methods are needed to reduce the risk of phase hits in wireless radio systems, especially when using QAM modulation or other PSK/FSK schemes.

SUMMARY

In one aspect, the present invention provides a wireless radio system defined by the present invention as set out in claim 1.

The frequency synthesizer module may be configured in a wireless radio system with an outdoor unit (ODU) and an indoor unit (IDU), wherein the frequency synthesizer is disposed in the ODU. The frequency synthesizer module may further comprise an insulating material disposed within a wall of the enclosure and the heater module. The insulating material may wrap at least a portion of the heater module. The enclosure may have electromagnetic shielding properties. The heater module may be substantially electrically isolated from the frequency synthesizer. The heater module may be positioned near or within the enclosure. The heater module may further include a posistor (thermistor with positive temperature coefficient) having an impedance value adapted to vary based on temperature; and a voltage regulator having an input pin adapted for receiving a varying input voltage, an output pin adapted for providing a modifiable output voltage to the heater element for adaptively adjusting the heat generated by the heater element based on the modifiable output voltage, and an adjust pin operatively coupled to the posistor for maintaining a substantially constant voltage at the adjust pin. The voltage regulator and posistor may be configured to activate the heater element when the frequency synthesizer is below room temperature, to activate the heater element at less than maximum power when the frequency synthesizer is between room temperature and a high-temperature threshold, e.g., about 65°C, and to substantially deactivate the heater element when the temperature is substantially at or above the high-temperature threshold. The frequency synthesizer module may be operative to control one or more frequency converters in the ODU.

In a further aspect, the present invention further provides a method defined by the present invention as set out in claim 9.

The method may be performed by a wireless radio with an outdoor unit (ODU) and an indoor unit (IDU), wherein the frequency synthesizer is disposed in the ODU. The insulating material may be disposed between a wall of the enclosure and the heater module The insulating material may wrap at least a portion of the heater module. The enclosure may have electromagnetic shielding properties. The heater module may be substantially electrically isolated from the frequency synthesizer. The heater module may be positioned near or within the enclosure. The heater module may further include a posistor having an impedance value adapted to vary with temperature; and a voltage regulator having an input pin adapted for receiving a varying input voltage, an output pin adapted for providing a modifiable output voltage to the heater element for adaptively adjusting the heat generated by the heater element based on the modifiable output voltage, and an adjust pin operatively coupled to the posistor for maintaining a substantially constant voltage at the adjust pin The method may further comprise configuring the voltage regulator and the posistor to activate the heater element, for adaptively adjusting the heat, when the frequency synthesizer is below room temperature, to activate the heater element at less than maximum power when the frequency synthesizer is between about room temperature and a high-temperature threshold, e.g., about 65°C, and to substantially deactivate the heater element when the temperature is substantially at the high-temperature threshold and above The method may be operative to control one or more frequency converters in the ODU.

Per another embodiment, the present invention provides a method comprising obtaining a frequency synthesizer having predetermined operiting characteristics when within a predetermined temperature range, obtaining a heater module with a heater element operative to adaptively generate heat based on ambient temperature, and positioning the heater element in thermal communication with the frequency synthesizer to adaptively heat the frequency synthesizer to within the predetermined temperature range

Per yet another embodiment, the present invention provides a wireless radio system, comprising an ODU including a transmit frequency upconverter for upconverting an outgoing signal to a transmit frequency; a receive frequency downconverter for downconverting an incoming signal from a receive frequency to a lower frequency; and a frequency synthesizer module coupled to the transmit frequency upconverter and to the receive frequency downconverter, the frequency synthesizer module having an enclosure; a frequency synthesizer housed within the enclosure; and a heater module having a heating element in thermal communication with the frequency synthesizer to adaptively adjust temperature of the frequency synthesizer. The wireless radio system may further comprise an IDU and a transceiver antenna, each coupled to the ODU. The incoming signal and outgoing signal may be quadrature amplitude modulated (QAM) signals.

BRIEF DESCRIPTION OF THE DRAWINGS

Figure 1A is a symbolic diagram illustrating circular QAM modulation constellation space in accordance with the prior art.

Figure 1B is a symbolic diagram illustrating rectangular QAM modulation constellation space in accordance with the prior art.

Figure 2 is a block diagram illustrating a wireless radio system, in accordance with an embodiment of the present invention.

Figure 3 is a block diagram illustrating details of the frequency synthesizer module of Figure 2, in accordance with an embodiment of the present invention.

Figure 4 is a block diagram illustrating details of the frequency synthesizer module of Figure 1, in accordance with an embodiment of the present invention.

Figure 5 is a circuit diagram illustrating details of an example heater module of Figure 2, in accordance with an embodiment of the present invention.

Figure 6 is a graphical diagram illustrating total power dissipation of the heater module of Figure 5 relative to temperature and various input voltages ($V_{in}$), in accordance with an embodiment of the present invention.

Figure 7 is a graphical diagram illustrating total power dissipation of the heater module of Figure 5 relative to temperature and an input voltage ($V_{in}$), in accordance with an embodiment of the present invention.

DETAILED DESCRIPTION

The following description is provided to enable any person skilled in the art to make and use the invention, and is provided in the context of a particular application and its requirements. Various modifications to the embodiments are possible to those skilled in the art, and the generic principles defined herein may be applied to these and other embodiments and applications. Thus, the present invention is not intended to be limited to the embodiments shown, but is to be accorded the widest scope consistent with the principles, features and teachings disclosed herein.

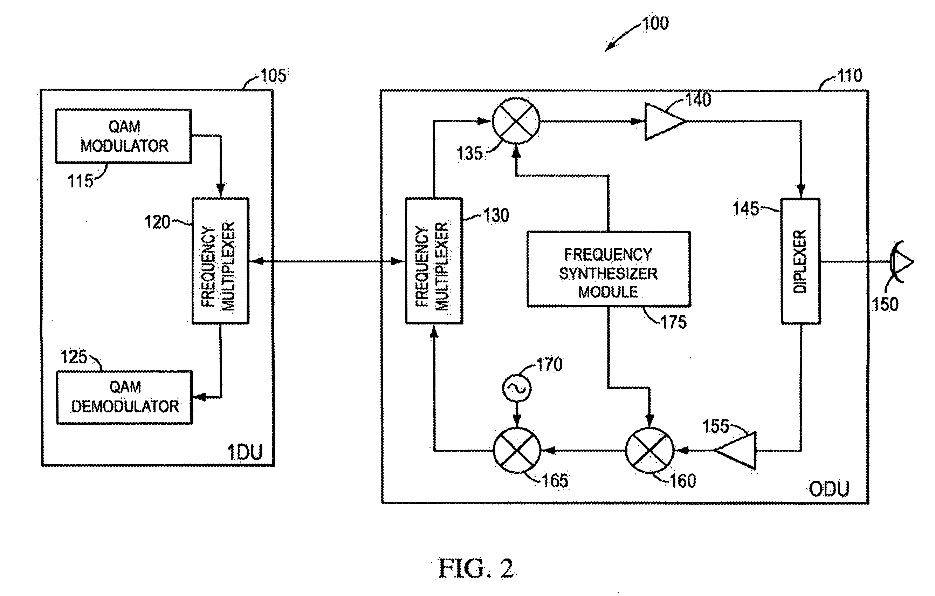

Figure 2 is a block diagram illustrating a wireless radio system 100, in accordance with an embodiment of the present invention. The wireless radio system 100 includes an IDU 105, coupled to an ODU 110, in turn coupled to a transmit/receive antenna 150. The IDU 105 includes a QAM modulator 115, which modulates outgoing QAM signal to be transmitted. The QAM modulator 115 is coupled to a frequency multiplexer 120, which in turn is coupled to transmit the outgoing QAM signal to the ODU 110. The IDU 105 also includes a QAM demodulator 125. which demodulates incoming QAM signal. The QAM demodulator 125 is coupled to the frequency multiplexer 120, which in turn is coupled to receive the incoming QAM signal from the ODU 110. The frequency multiplexer 120 functions to transmit and receive the QAM signals to and from the ODU 110.

The ODU 110 includes a frequency multiplexer 130, which is coupled to the frequency multiplexer 120 of the IDU 105 and cooperates with the frequency multiplexer 120 of the IDU 105 to communicate therebetween the outgoing QAM signal and the incoming QAM signal. The frequency multiplexer 130 is coupled to a transmit frequency upconverter 135, which uses a frequency synthesizer module 175 to upconvert the transmit frequency of the outgoing QAM signal from its original or intermediate transmit frequency (e.g., about 2 GHz) to the transmit frequency {e.g., about 6-38 GHz). The transmit frequency upconverter 135 is coupled to a power amplifier 140, which in turn is coupled to a diplexer 145, which in turn is coupled to the transmit/receive antenna 150. Although the ODU 110 is shown to include only one transmit frequency upconverter 135, one skilled in the art will recognize that any number of transmit frequency upconverters can be used.

The ODU 110 further includes a low noise amplifier 155, which is coupled to receive the incoming QAM signal from the diplexer 145. The low noise amplifier 155 is coupled to a receive frequency downconverter 160, which uses the frequency synthesizer module 175 to downconvert the receive frequency (e.g., about 6-38 GHz) of the incoming QAM signal to an intermediate receive frequency (e.g., about 1 GHz) The receive frequency downconverter 160 is coupled to a second receive frequency downconverter 165, which uses a local oscillator 170 to downconvert the intermediate receive frequency (e.g., about 1 GHz) of the incoming QAM signal to a second intermediate receive frequency (e.g., about 126 MHz). The second receive frequency downconverter 165 is coupled to the frequency multiplexer 130. Although frequency conversion by the transmit frequency upconverter 135 and the receive frequency downconverter 160 are being described as controlled by the same frequency synthesizer module 175, one skilled in the art will recognize that separate frequency synthesizers may alternatively be used. Further, although the second receive frequency downconverter 165 is not shown as controlled by the frequency synthesizer module 175, one skilled in the art will recognize that it can Still further, although the ODU 110 is shown to include two receive frequency downconverters 160 and 165, one skilled in the art will recognize that any number of receive frequency downconverters can be used

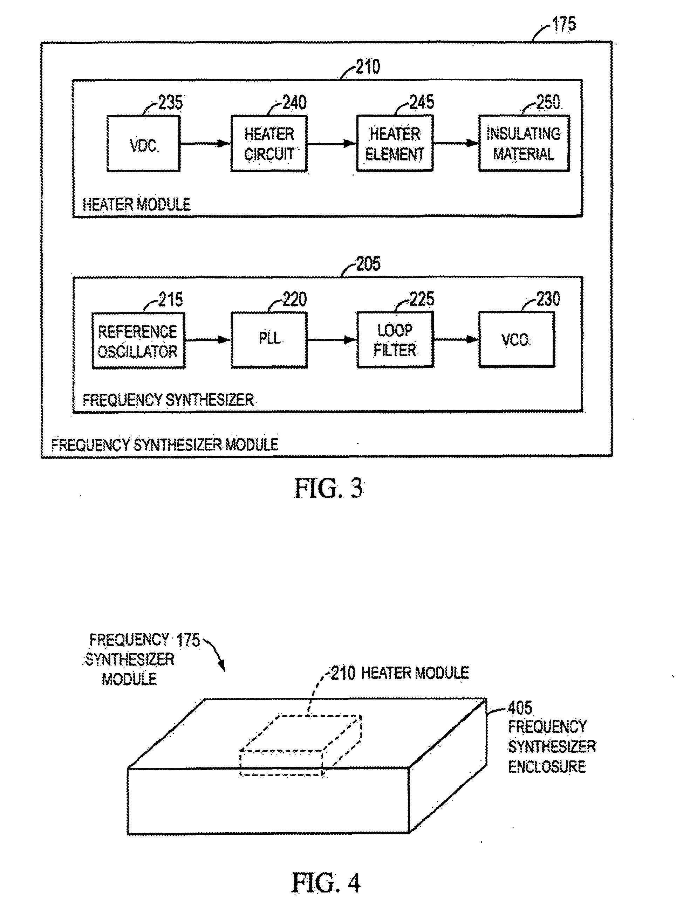

In one embodiment, the frequency synthesizer module 175 is maintained at a stable temperature to avoid temperature fluctuations caused by ambient temperature changes, thus reducing the risk of phase hits Maintaining the frequency synthesizer module 175 at a stable temperature avoids the costs incurred by repeated thermal testing during manufacturing, avoids the necessity for unreasonably careful selection and assembly of synthesizer 175 components (e.g., costly and difficult-to-find quality VCOs, reference oscillators, loop filters, etc, ), provides better definition and more opportunities for suppliers of frequency synthesizer 175 components to meet wireless radio system 100 requirements, enables selection of frequency synthesizer 175 components from different vendors, etc Further, the frequency synthesizer module 175 may reduce thermal testing during manufacturing to only a sample group. The frequency synthesizer module 175 may assure that its temperature is always maintained above 0°C to avoid cold temperature levels where phase hits are most likely. The frequency synthesizer module 175 is dcsiribed in greater detail below with reference to Figure 3.

Figure 3 is a block diagram illustrating details of the frequency synthesizer module 175, in accordance with an embodiment of the present invention. The frequency synthesizer module 175 includes a frequency synthesizer 205 and a heater module 210. The frequency synthesizer 205 includes a reference oscillator 215, coupled to a phase lock loop (PLL) 220, in turn coupled to a loop filter 225, and in turn coupled to a voltage controlled oscillator 230. While the operation of the frequency synthesizer 205 components is conventional the components 215-230 need not be the expensive, carefully selected conventional components (since the components 215-230 are heated and optionally maintained at a stable temperature). For convenience, the operation of the frequency synthesizer 205 is generally described. The reference osccillator 215 supplies a reference signal having a predetermined frequency The VCO 230 generates an output signal having a frequency that vanes in response to a control voltage The PLL 220 compares the phase of output signal from the VCO 230 and the phase of the reference signal from the reference oscillator 215 to provide a control pulse corresponding to the phase difference. The loop filter 225 uses the control pulse from the PLL 220 to generate a control voltage to control the output signal of the VCO 230.

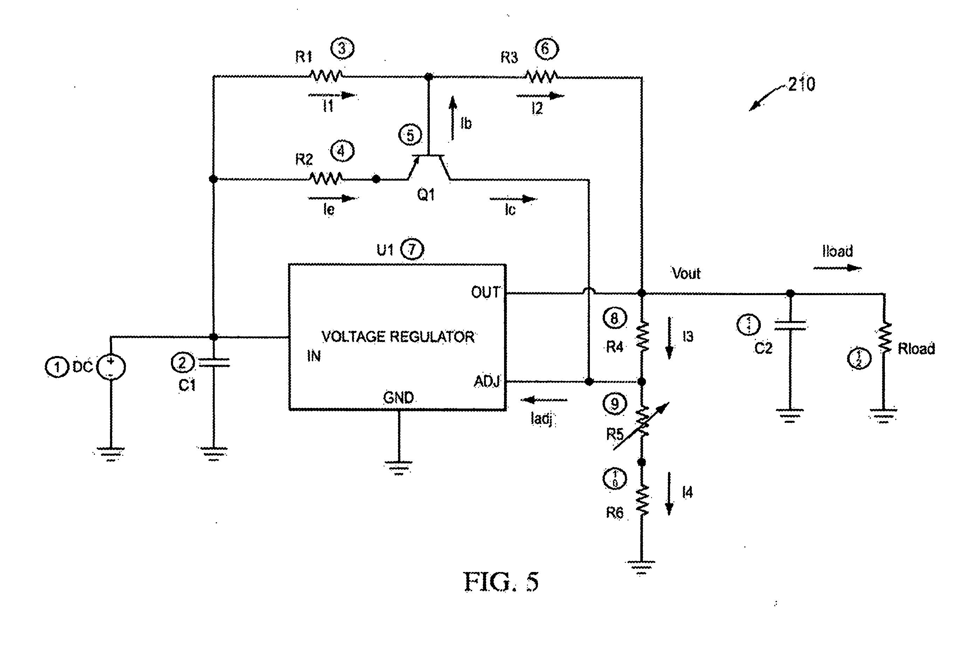

The heater module 210 includes a DC voltage source ($V_{DC}$) 235, which powers a beater circuit 240. The heater circuit 240 adaptively drives a heater element 245, which adaptively heats the frequency synthesizer 205. The heater module 210 may be completely wrapped by insulating material 250, e.g., to insulate the heater module 210 physically and electromagnetically. In one embodiment, the heater module 210 operates to deliver proportionally controlled heat to or within the mechanical enclosure of the frequency synthesizer 205. In one embodiment, the heater module 210 uses the 48 $V_{DC}$ voltage supply in the IDU 105 while totally isolating the two circuits. Accordingly, the heater module 210 may provide uniform and controlled heating without interfering with frequency synthesizer 205 function, and may maintain system requirements of frequency tuning and DC power consumption. Additional details of the heater frequency synthesizer 175 are described below with reference to Figure 4. Additional details of an example heater module 210 are described below with reference to Figure 5.

Figure 4 is a block diagram illustrating details of the frequency synthesizer module 175, in accordance with an embodiment of the present invention. As shown, the heater module 210 is positioned inside the enclosure 405 of the frequency synthesizer 210 In various embodiments, the heater module 210 may be disposed at any position (e.g , central top, left top side, right top side, corner top side, lower left side, etc,) on any internal or external wall of the enclosure 405 of the frequency synthesizer 210 or within the enclosure 405 material itself. The heater element 245 of the heater module 210 must be in thermal communication, directly or indirectly, with the frequency synthesizer 205. Positioning the heater module 210 on an external wall may add to isolate the two circuits. Positioning the heater module 210 on an internal wall may increase heater module 210 efficiency and add to shield the heater module 210 from electromagnetic interference (EMI). Positioning the heater module 210 within the enclosure 405 material itself may add to isolate the two circuits, increase efficiency, and shield the heater module 210 from EMI.

Figure 5 is a circuit diagram illustrating details of the heater module 210, in accordance with an embodiment of the present invention. The heater module 210 includes Input Capacitor 2 (C1), Voltage Regulator 7 (U1), PNP Transistor 5 (Q1). Positive Temperature Coefficient Thermistor (Posistor) 9 (R5). Heating Resistor 12 ($R_{load}$), Output Capacitor 11 (C2), Base Resistors 3 (R1) and 6 (R3), Emitter Resistor 4 (R2), and Voltage Setting Resistors 8 (R4) and 10 (R6). The heater module 210 is powered by Battery Voltage 1, which may come from the IDU 105. Comparing the heater module 210 generally shown in Figure 2 and the heater module 210 specifically shown in Figure 5, the general VDC 235 of Figure 2 is specifically shown as Battery Voltage i (DC), possibly in combination with Input Capacitor 2 (C1). The general heater element 250 of Figure 2 is specifically shown as Heating Resistor 12, possible in combination with Voltage Regulator 7 (U1). The general heater circuit 240 is specifically shown as all other circuit elements of the heater module 210 of Figure 5. The general insulating material 250 of Figure 2 is not shown in Figure 5.

The Input Capacitor 2 (C1) operates as a bypassing capacitor to allow the heater module 210 to be remotely located from the battery. The Output Capacitor 11 (C2) improves stability of the Voltage Regulator 7 (U1) and transient response of the heater module 210.

The output voltage ($V_{out}$) of the Voltage Regulator 7 (U1) is set by the ratio of Resistor 8 (R4) and the sum of Posistor 9 (R5) and Resistor 10 (R6), The Voltage Regulator 7 (U1) servos the output voltage ($V_{out}$) to maintain the voltage at the adjust pin (ADJ) at a reference voltage, e.g., $+1.24V_{DC}$ above ground. The current 14 is equal to:

$$I4 = 1.24V/(R5 + R6) \tag{1}$$

At the adjust pin (ADJ) of the Voltage Regulator 7 (U1), the following condition exists:

$$Ic + I3 = Iadj + I4 \tag{2}$$

Therefore:

$$I3 = Iadj + I4 - Ic \tag{3}$$

where Iadj is the ADJ pin bias current of the voltage regulator, and Ic is the collector current of Transistor 5 (Q1).

At Transistor 5 (Q1), the following relationships exist:

$$I2 = I1 + Ib \tag{4}$$

$$Ic = Ib \times Beta\ Gain\ of\ the\ Transistor\ 5 \tag{5}$$

$$Ie = Ic + Ib \tag{6}$$

where Ib. Ic. and Ie are base current, collector current and emitter current of Transistor 5 (Q1), respectively, I1 and I2 are the currents across Resistor 3 (R1) and Resistor 6 (R3), respectively.

The current of the Heating Resistor 12 ($R_{load}$) is given by:

$$I_{load} = V_{out}/R_{load} \qquad (7)$$

The output voltage of the Voltage Regulator 7 (U1) can be calculated using the following formula:

$$V_{out} = 1.24V \, [1 + R4/(R5 + R6)] + (I3)(R4) \qquad (8)$$

Operation at room temperature level

At low battery input voltage level, the output voltage of the Voltage Regulator 7 (U1) is close to the input voltage, different only by a drop-out voltage of the Voltage Regulator 7 (UI). Ic is very small (e.g., insignificant). The power dissipation P1 on the Voltage Regulator 7 (U1) is also small. The power dissipation on the Heating Resistor I2 ($R_{load}$) is given by:

$$P2 = (V_{out})^2/R_{load} \qquad (9)$$

The total power dissipation of the heater module 210 is the sum of the power dissipation of the Voltage Regulator 7 (U1) and the power dissipation of the Heating Resistor 12 ($R_{load}$):

$$P_{total} = P1 + P2 \qquad (10)$$

As the battery input voltage level increases, the collector current Ic of Transistor 5 (Q1) also increases, which causes the current 13 to decrease in accordance with Equation (3). As a consequence the output voltage ($V_{out}$) of the Voltage Regulator 7 (U1) decreases in accordance with Equation (8).

The power dissipation P1 on the Voltage Regulator 7 (U1) starts increasing due to a larger drop-out voltage Power dissipation on the Heating Resistor I2 ($R_{load}$) starts decreasing due to the lower output voltage ($V_{out}$) of the Voltage Regulator 7 (U1) With optimized values of the Transistor 5 (Q1) Base Resistors 3 (R1) and 6 (R3), and Emitter Resistor 4 (R2), total power dissipation of the heater module 210 remains constant, as the battery input voltage 1(DC) varies within the specification limit (-26 to -60 $V_{DC}$). The insulating material 250 may keep the battery voltage floating in the heater module 210. which operates as if the input voltage is positive. Since the heater module 210 does not share the same battery Voltage directly with the frequency synthesizer 205, the heater module 210 remains isolated from the frequency synthesizer 205 and has no effect on frequency synthesizer 205 function.

Operation over temperature levels

Between room temperature (e.g., +25°C) and cold temperature (e.g., -33 °C), the resistance value of Posistor 9 (R5) remains nearly unchanged. Therefore, between these two temperatures, total power dissipation of the heater module 210 remains nearly unchanged.

Between room temperature (e.g., +25°C) and about +40°C, the resistance value of Posistor 9 (R5) starts increasing slowly. As a consequence the output voltage ($V_{out}$) of the Voltage Regulator 7 (U1) starts decreasing slowly. Total power dissipation also decreases.

Above about +40°C, the resistance value of Posistor 9 (R5) starts increasing rapidly. As a a consequence, the output voltage of the Voltage Regulator 7 (U1) starts decreasing rapidly. Total power dissipation also starts decreasing rapidly. At about +65°C and above, the resistance value of Posistor 9 (R5) is high, total power dissipation is small, and the heater module 210 is nearly turned off.

in summary, in one embodiment, the heater module 210 provides uniform and controlled heating effect from variant -48 $V_{DC}$ battery voltages, without interfering with frequency synthesizer 205 function. Two alternate heater elements 245 include the Voltage Regulator 7 (UI) and the Heating Resistor I2 ($R_{load}$). Between room and cold temperatures, the heater module 210 raises the temperature of the frequency synthesizer 205 above 0°C to prevent low temperatures where phase hits are most likely. When the frequency synthesizer 205 is at higher temperatures (above +25°C) where phase hits are not as likely, the heater module 210 gradually backs off. The heater module 210 turns off when the temperature reaches +65°C and above

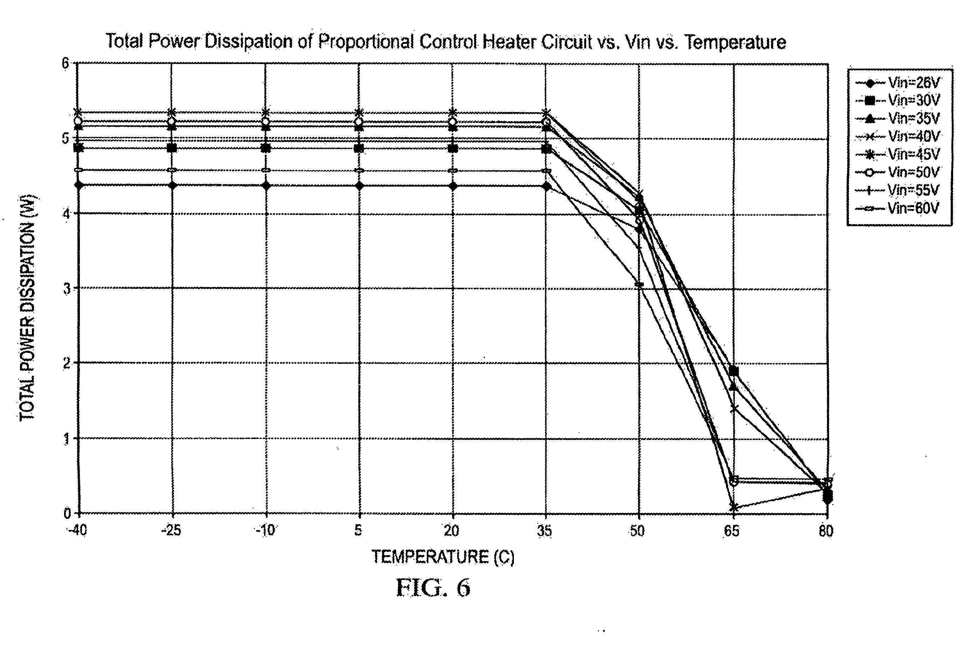

Figure 6 is a graphical diagram illustrating total power dissipation of the heater module 210 relative to temperature and various input voltages ($V_{in}$), in accordance with an embodiment of the present invention. As shown, total power dissipation of the heater module 210 is constant when temperatures are below +35°C (effectively regardless of $V_{in}$), drops gradually between about +35°C and about +65°C (again, effectively) regardless of $V_{in}$), and is low when temperatures are above about +65°C and above (again effectively regardless of $V_{in}$).

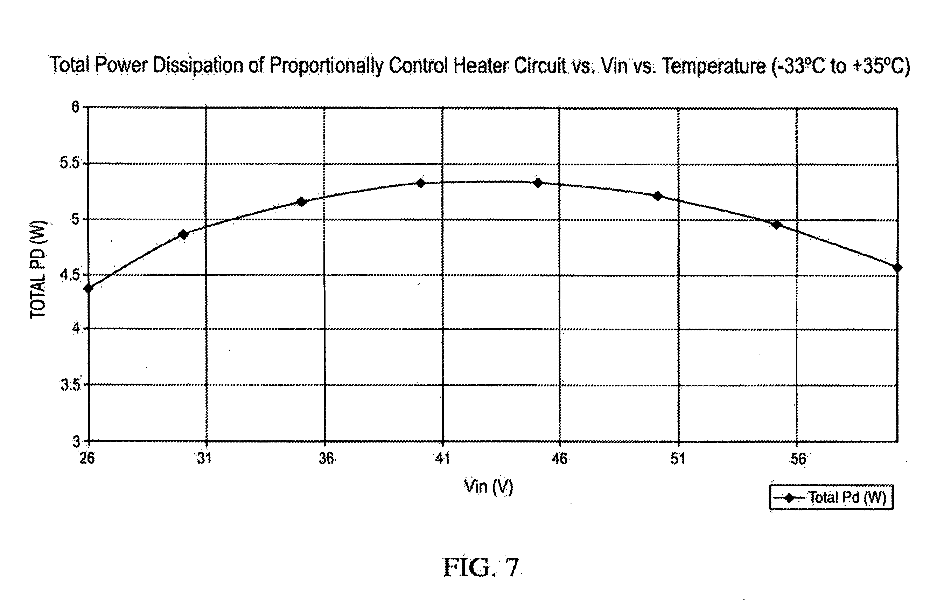

Figure 7 is a graphical diagram illustrating total power dissipation of the heater module 210 relative to temperature and an input voltage ($V_{in}$), in accordance with an embodiment of the present invention. As shown the total power dissipation across the voltage range of 26V to 60V (while the temperature is at or below room temperature) is relatively constant, remaining between 4 3W (at 26V) and 5 3W (at 42V).

The foregoing description of the preferred embodiments of the present invention is by way of example only, and other variations and modifications of the above-described embodiments and methods are possible in light of the foregoing teaching. The embodiments described herein are not intended to be exhaustive or limiting. The present invention is limited only by the following claims.

## Claims

1. A wireless radio system (100) with an outdoor unit 'ODU' (110) and an indoor unit 'IDU' (105), the IDU (105) having a voltage supply (-48$V_{DC}$), wherein a frequency synthesizer module (175) is disposed in the ODU (110), the frequency synthesizer module (175) comprising:

   an enclosure (405);
   a frequency synthesizer (205) housed within the enclosure (405); and
   a heater module (210) positioned on the wall of the enclosure (405), or positioned within the enclosure (405) material, the heating module including a heater element (245) in direct or indirect thermal communication with the frequency synthesizer (205), the heater module configured to use the voltage supply (-48$V_{DC}$) of the IDU, the heater module being totally electrically isolated from the frequency synthesizer (205), the heater module (210) being operative to adaptively heat the frequency synthesizer (205) by delivering heat to or within the enclosure (405) based on an ambient temperature within the enclosure (405) when the temperature of the frequency synthesizer (205) falls below a specified temperature threshold, thereby reducing likelihood of phase hits to the frequency synthesizer (205).

2. The frequency synthesizer module (175) of claim 1, further comprising an insulating material (250) disposed between the wall of the enclosure (405) and the heater module (210).

3. The frequency synthesizer module (175) of claim 2, wherein the heater module (210) is completely wrapped by the insulating material to insulate the heater module (210) physically and electromagnetically.

4. The frequency synthesizer module (175) of claim 1, wherein the enclosure (405) has electromagnetic shielding properties.

5. The frequency synthesizer module (175) of claim 1, wherein the heater module (210) further includes
   a posistor (9) having an impedance value adapted to vary based on temperature; and
   a voltage regulator (7) having an input pin (IN) adapted for receiving a varying input voltage, an output pin (OUT) adapted for providing a modifiable output voltage to the heater element (245) for adaptively adjusting the heat generated by the heater element (245) based on the modifiable output voltage, and an adjust pin (ADJ) operatively coupled to the posistor (9) for maintaining a substantially constant voltage at the adjust pin (ADJ).

6. The frequency synthesizer module (175) of claim 5, wherein, for adaptively adjusting the heat, the voltage regulator (7) and posistor (9) are configured to activate the heater element (245) when a temperature of the frequency synthesizer (205) is below room temperature, to activate the heater element (245) at less than maximum power when the temperature of the frequency synthesizer (205) is between about room temperature and a high-temperature threshold, and to substantially deactivate the heater element (245) when the temperature of the frequency synthesizer (205) is substantially at or above the specified temperature threshold.

7. The frequency synthesizer module (175) of claim 6, wherein the specified temperature threshold is about 65°C.

8. The frequency synthesizer module (175) of claim 1, operative to control one or more frequency converters (135) in the ODU (110).

9. A method, comprising:

providing a wireless radio system (100) with an outdoor unit 'ODU' (110) and an indoor unit 'IDU' (105), the IDU(105) having a voltage supply (-48$V_{DC}$), wherein a frequency synthesizer module (175) is disposed in the ODU (110), the frequency synthesizer module (175) including a frequency synthesizer (205) housed in enclosure (405);
providing a heater module (210) positioned on the wall of the enclosure (405), or positioned within the enclosure (405) material, the heater module (210) having a heater element (245) in direct or indirect thermal communication with the frequency synthesizer (205), the heater module configured to use the voltage supply (-48$V_{DC}$) of the IDU, the heater module being totally electrically isolated from the frequency synthesizer (205); and
using the heater module (210) to adaptively heat the frequency synthesizer (205) by delivering heat to or within the enclosure (405) based on an ambient temperature within the enclosure (405) when the temperature of the frequency synthesizer (205) falls below a specified temperature threshold, thereby reducing likelihood of phase hits to the frequency synthesizer; and
maintaining the frequency synthesizer (205) at a stable temperature to avoid temperature fluctuations caused by ambient temperature changes outside the enclosure (405).

10. The method of claim 9, wherein insulating material (250) is disposed between the wall of the enclosure (405) and the heater module (210) is completely wrapped by the insulating material to insulate the heater module physically and electromagnetically.

11. The method of claim 9, wherein the enclosure (405) has electromagnetic shielding properties.

12. The method of claim 9, wherein the heater module (210) further includes
a posistor (9) having an impedance value adapted to vary with temperature; and
a voltage regulator (7) having an input pin (IN) adapted for receiving a varying input voltage, an output pin (OUT) adapted for providing a modifiable output voltage to the heater element (245) for adaptively adjusting the heat generated by the heater element (245) based on the modifiable output voltage, and an adjust pin (ADJ) operatively coupled to the posistor (9) for maintaining a substantially constant voltage at the adjust pin (ADJ).

13. The method of claim 12 further comprising configuring the voltage regulator (7) and the posistor (9) to activate the heater element (245), for adaptively adjusting the heat, when a temperature of the frequency synthesizer (205) is below room temperature, to activate the heater element (245) at less than maximum power when the temperature of the frequency synthesizer (205) is between about room temperature and the specified threshold, and to substantially deactivate the heater element (245) when the temperature of the frequency synthesizer (205) is substantially at the specified threshold and above.

14. The method of claim 13 wherein the specified threshold is about 65°C.

15. The method of claim 9, operative to control one or more frequency converters (135) in the ODU (110).

16. A wireless radio system (100) as claimed in claim 1, wherein the ODU (110), includes:

a transmit frequency upconverter (135) for upconverting an outgoing signal to a transmit frequency; and
a receive frequency downconverter (160) for downconverting an incoming signal from a receive frequency to a lower frequency;
wherein the frequency synthesizer module (175) is coupled to the transmit frequency upconverter (135) and to the receive frequency downconverter (160).

17. The wireless radio system (100) of claim 16 wherein, a transceiver antenna (150) is coupled to the ODU (110).

**18.** The wireless radio system (100) of claim 16, wherein the incoming signal and outgoing signal are quadrature amplitude modulated (QAM) signals.

**Patentansprüche**

**1.** Drahtloses Funksystem (100) mit einer Außeneinheit 'ODU' (110) und einer Inneneinheit 'IDU' (105), wobei die IDU (105) eine Spannungsversorgung (-48 V Gleichspannung) hat, worin ein Frequenzsynthesizermodul (175) in der ODU (110) angeordnet ist, wobei das Frequenzsynthesizermodul (175) umfasst:

ein Gehäuse (405);
einen im Gehäuse (405) untergebrachten Frequenzsynthesizer (205); und
ein Heizmodul (210), das auf der Wand des Gehäuses (405) positioniert ist oder im Material des Gehäuses (405) positioniert ist, wobei das Heizmodul ein Heizelement (245) in direkter oder indirekter thermischer Kommunikation mit dem Frequenzsynthesizer (205) aufweist, wobei das Heizmodul dafür konfiguriert ist, die Spannungsversorgung (-48 V Gleichspannung) der IDU zu verwenden, wobei das Heizmodul vom Frequenzsynthesizer (205) elektrisch völlig isoliert ist, wobei das Heizmodul (210) betriebsfähig ist, den Frequenzsynthesizer (205) adaptiv zu erwärmen, und zwar durch Zuführen von Wärme an das oder in dem Gehäuse (405) auf der Grundlage einer Umgebungstemperatur innerhalb des Gehäuses (405), wenn die Temperatur des Frequenzsynthesizers (205) unter einen festgelegten Temperaturschwellwert fällt, wodurch die Wahrscheinlichkeit von Phasensprüngen des Frequenzsynthesizers (205) verringert wird.

**2.** Frequenzsynthesizermodul (175) nach Anspruch 1, ferner ein Isoliermaterial (250) umfassend, das zwischen der Wand des Gehäuses (405) und dem Heizmodul (210) angeordnet ist.

**3.** Frequenzsynthesizermodul (175) nach Anspruch 2, worin das Heizmodul (210) vollständig durch das Isoliermaterial umhüllt ist, um das Heizmodul (210) physisch und elektromagnetisch zu isolieren.

**4.** Frequenzsynthesizermodul (175) nach Anspruch 1, worin das Gehäuse (405) elektromagnetisch abschirmende Eigenschaften hat.

**5.** Frequenzsynthesizermodul (175) nach Anspruch 1, worin das Heizmodul (210) ferner aufweist:

einen Kaltleiter (9) mit einem Impedanzwert, der dafür eingerichtet ist, auf der Grundlage der Temperatur zu variieren; und
einen Spannungsregler (7) mit einem Eingangsanschluss (IN), der zum Empfangen einer schwankenden Eingangsspannung eingerichtet ist, einem Ausgangsanschluss (OUT), der zum Bereitstellen einer modifizierbaren Ausgangsspannung für das Heizelement (245) zum adaptiven Regulieren der durch das Heizelement (245) erzeugten Wärme auf der Grundlage der modifizierbaren Ausgangsspannung eingerichtet ist, und einem Regulieranschluss (ADJ), der zum Beibehalten einer im Wesentlichen konstanten Spannung am Regulieranschluss (ADJ) betrieblich mit dem Kaltleiter (9) gekoppelt ist.

**6.** Frequenzsynthesizermodul (175) nach Anspruch 5, worin der Spannungsregler (7) und der Kaltleiter (9) dafür konfiguriert sind, zum adaptiven Regulieren der Wärme das Heizelement (245) zu aktivieren, wenn eine Temperatur des Frequenzsynthesizers (205) unter Zimmertemperatur liegt, das Heizelement (245) mit weniger als der Maximalleistung zu aktivieren, wenn die Temperatur des Frequenzsynthesizers (205) zwischen etwa Zimmertemperatur und einem Hochtemperaturschwellwert liegt, und das Heizelement (245) im Wesentlichen zu deaktivieren, wenn die Temperatur des Frequenzsynthesizers (205) im Wesentlichen auf oder über dem festgelegten Temperaturschwellwert liegt.

**7.** Frequenzsynthesizermodul (175) nach Anspruch 6, worin der festgelegte Temperaturschwellwert etwa 65 °C beträgt.

**8.** Frequenzsynthesizermodul (175) nach Anspruch 1, das betriebsfähig ist, einen oder mehrere Frequenzwandler (135) in der ODU (110) zu steuern.

**9.** Verfahren, umfassend:

Bereitstellen eines drahtlosen Funksystems (100) mit einer Außeneinheit 'ODU' (110) und einer Inneneinheit 'IDU' (105), wobei die IDU (105) eine Spannungsversorgung (-48 V Gleichspannung) hat, worin ein Frequenzsynthesizermodul (175) in der ODU (110) angeordnet ist, wobei das Frequenzsynthesizermodul (175) einen in einem Gehäuse (405) untergebrachten Frequenzsynthesizer (205) aufweist;

Bereitstellen eines Heizmoduls (210), das auf der Wand des Gehäuses (405) positioniert ist oder im Material des Gehäuses (405) positioniert ist, wobei das Heizmodul (210) ein Heizelement (245) in direkter oder indirekter thermischer Kommunikation mit dem Frequenzsynthesizer (205) aufweist, wobei das Heizmodul dafür konfiguriert ist, die Spannungsversorgung (-48 V Gleichspannung) der IDU zu verwenden, wobei das Heizmodul vom Frequenzsynthesizer (205) elektrisch völlig isoliert ist; und

Verwenden des Heizmoduls (210), um den Frequenzsynthesizer (205) adaptiv zu erwärmen, und zwar durch Zuführen von Wärme an das oder in dem Gehäuse (405) auf der Grundlage einer Umgebungstemperatur innerhalb des Gehäuses (405), wenn die Temperatur des Frequenzsynthesizers (205) unter einen festgelegten Temperaturschwellwert fällt, wodurch die Wahrscheinlichkeit von Phasensprüngen des Frequenzsynthesizers verringert wird; und

Halten des Frequenzsynthesizers (205) auf einer stabilen Temperatur, um Temperaturschwankungen zu vermeiden, die durch Umgebungstemperaturänderungen außerhalb des Gehäuses (405) verursacht werden.

10. Verfahren nach Anspruch 9, worin Isoliermaterial (250) zwischen der Wand des Gehäuses (405) angeordnet ist und das Heizmodul (210) vollständig durch das Isoliermaterial umhüllt ist, um das Heizmodul physisch und elektromagnetisch zu isolieren.

11. Verfahren nach Anspruch 9, worin das Gehäuse (405) elektromagnetisch abschirmende Eigenschaften hat.

12. Verfahren nach Anspruch 9, worin das Heizmodul (210) ferner aufweist:

einen Kaltleiter (9) mit einem Impedanzwert, der dafür eingerichtet ist, auf der Grundlage der Temperatur zu variieren; und

einen Spannungsregler (7) mit einem Eingangsanschluss (IN), der zum Empfangen einer schwankenden Eingangsspannung eingerichtet ist, einem Ausgangsanschluss (OUT), der zum Bereitstellen einer modifizierbaren Ausgangsspannung für das Heizelement (245) zum adaptiven Regulieren der durch das Heizelement (245) erzeugten Wärme auf der Grundlage der modifizierbaren Ausgangsspannung eingerichtet ist, und einem Regulieranschluss (ADJ), der zum Beibehalten einer im Wesentlichen konstanten Spannung am Regulieranschluss (ADJ) betrieblich mit dem Kaltleiter (9) gekoppelt ist.

13. Verfahren nach Anspruch 12, ferner umfassend: Konfigurieren des Spannungsreglers (7) und des Kaltleiters (9), um zum adaptiven Regulieren der Wärme das Heizelement (245) zu aktivieren, wenn eine Temperatur des Frequenzsynthesizers (205) unter Zimmertemperatur liegt, das Heizelement (245) mit weniger als der Maximalleistung zu aktivieren, wenn die Temperatur des Frequenzsynthesizers (205) zwischen etwa Zimmertemperatur und dem festgelegten Schwellwert liegt, und das Heizelement (245) im Wesentlichen zu deaktivieren, wenn die Temperatur des Frequenzsynthesizers (205) im Wesentlichen auf dem festgelegten Temperaturschwellwert und darüber liegt.

14. Verfahren nach Anspruch 13, worin der festgelegte Temperaturschwellwert etwa 65 °C beträgt.

15. Verfahren nach Anspruch 9, das betriebsfähig ist, einen oder mehrere Frequenzwandler (135) in der ODU (110) zu steuern.

16. Drahtloses Funksystem (100) nach Anspruch 1, worin die ODU (110) aufweist:

einen Sendefrequenz-Aufwärtswandler (135) zum Aufwärtswandeln eines abgehenden Signals zu einer Sendefrequenz; und

einen Empfangsfrequenz-Abwärtswandler (160) zum Abwärtswandeln eines eingehenden Signals von einer Empfangsfrequenz zu einer niedrigeren Frequenz;

worin das Frequenzsynthesizermodul (175) mit dem Sendefrequenz-Aufwärtswandler (135) und mit dem Empfangsfrequenz-Abwärtswandler (160) gekoppelt ist.

17. Drahtloses Funksystem (100) nach Anspruch 16, worin eine Sendeempfängerantenne (150) mit der ODU (110) gekoppelt ist.

18. Drahtloses Funksystem (100) nach Anspruch 16, worin das eingehende Signal und das abgehende Signal quadraturamplitudenmodulierte (QAM-)Signale sind.

**Revendications**

1. Système radio sans fil (100) doté d'une unité extérieure « ODU » (110) et d'une unité intérieure « IDU » (105), l'unité IDU (105) présentant une alimentation en tension (48V$_{DC}$), dans lequel un module de synthétiseur de fréquence (175) est disposé dans l'unité ODU (110), le module de synthétiseur de fréquence (175), comprenant :

un boîtier (405) ;
un synthétiseur de fréquence (205) logé à l'intérieur du boîtier (405) ; et
un module chauffant (210) positionné sur la paroi du boîtier (405), ou positionné à l'intérieur du matériau du boîtier (405), le module chauffant incluant un élément chauffant (245) en communication thermique directe ou indirecte avec le synthétiseur de fréquence (205), le module chauffant étant configuré de manière à utiliser l'alimentation en tension (-48V$_{DC}$) de l'unité IDU, le module chauffant étant totalement isolé électriquement du synthétiseur de fréquence (205), le module chauffant (210) étant exploitable de manière à chauffer de façon adaptative le synthétiseur de fréquence (205) en fournissant de la chaleur au boîtier ou au sein du boîtier (405) sur la base d'une température ambiante à l'intérieur du boîtier (405) lorsque la température du synthétiseur de fréquence (205) passe sous un seuil de température spécifié, ce qui permet de réduire par conséquent la probabilité de variations brusques de phase au niveau du synthétiseur de fréquence (205).

2. Module de synthétiseur de fréquence (175) selon la revendication 1, comprenant en outre un matériau isolant (250) disposé entre la paroi du boîtier (405) et le module chauffant (210).

3. Module de synthétiseur de fréquence (175) selon la revendication 2, dans lequel le module chauffant (210) est totalement enveloppé par le matériau isolant en vue d'isoler le module chauffant (210) physiquement et électromagnétiquement.

4. Module de synthétiseur de fréquence (175) selon la revendication 1, dans lequel le boîtier (405) est doté de propriétés de blindage électromagnétique.

5. Module de synthétiseur de fréquence (175) selon la revendication 1, dans lequel le module chauffant (210) inclut en outre :

un posisteur (9) présentant une valeur d'impédance apte à varier sur la base de la température ; et
un régulateur de tension (7) présentant une broche d'entrée (IN) apte à recevoir une tension d'entrée variable, une broche de sortie (OUT) apte à fournir une tension de sortie modifiable à l'élément chauffant (245) en vue d'ajuster de manière adaptative la chaleur générée par l'élément chauffant (245) sur la base de la tension de sortie modifiable, et une broche d'ajustement (ADJ) fonctionnellement couplée au posisteur (9) en vue de maintenir une tension sensiblement constante au niveau de la broche d'ajustement (ADJ).

6. Module de synthétiseur de fréquence (175) selon la revendication 5, dans lequel, pour ajuster de manière adaptative la chaleur, le régulateur de tension (7) et le posisteur (9) sont configurés de manière à activer l'élément chauffant (245) lorsqu'une température du synthétiseur de fréquence (205) est inférieure à la température ambiante, à activer l'élément chauffant (245) à moins que la puissance maximale lorsque la température du synthétiseur de fréquence (205) est comprise entre environ la température ambiante et un seuil de température élevée, et à désactiver sensiblement l'élément chauffant (245) lorsque la température du synthétiseur de fréquence (205) est sensiblement égale ou supérieure au seuil de température spécifié.

7. Module de synthétiseur de fréquence (175) selon la revendication 6, dans lequel le seuil de température spécifié est d'environ 65 °C.

8. Module de synthétiseur de fréquence (175) selon la revendication 1, exploitable de manière à commander un ou plusieurs convertisseurs de fréquence (135) dans l'unité ODU (110).

9. Procédé, consistant à :

fournir un système radio sans fil (100) doté d'une unité extérieure « ODU » (110) et d'une unité intérieure « IDU » (105), l'unité IDU (105) présentant une alimentation en tension (-48V$_{DC}$), dans lequel un module de synthétiseur de fréquence (175) est disposé dans l'unité ODU (110), le module de synthétiseur de fréquence (175) incluant un synthétiseur de fréquence (205) logé à l'intérieur d'un boîtier (405) ;

fournir un module chauffant (210) positionné sur la paroi du boîtier (405), ou positionné à l'intérieur du matériau du boîtier (405), le module chauffant (210) incluant un élément chauffant (245) en communication thermique directe ou indirecte avec le synthétiseur de fréquence (205), le module chauffant étant configuré de manière à utiliser l'alimentation en tension (-48V$_{DC}$) de l'unité IDU, le module chauffant étant totalement isolé électriquement du synthétiseur de fréquence (205) ; et

utiliser le module chauffant (210) de manière à chauffer de façon adaptative le synthétiseur de fréquence (205) en fournissant de la chaleur au boîtier ou au sein du boîtier (405) sur la base d'une température ambiante à l'intérieur du boîtier (405) lorsque la température du synthétiseur de fréquence (205) passe sous un seuil de température spécifié, ce qui permet de réduire par conséquent la probabilité de variations brusques de phase au niveau du synthétiseur de fréquence ; et

maintenir le synthétiseur de fréquence (205) à une température stable en vue d'éviter des fluctuations de température occasionnées par des variations de la température ambiante à l'extérieur du boîtier (405).

10. Procédé selon la revendication 9, dans lequel du matériau isolant (250) est disposé entre la paroi du boîtier (405) et le module chauffant (210) est totalement enveloppé par le matériau isolant en vue d'isoler le module chauffant physiquement et électromagnétiquement.

11. Procédé selon la revendication 9, dans lequel le boîtier (405) est doté de propriétés de blindage électromagnétique.

12. Procédé selon la revendication 9, dans lequel le module chauffant (210) inclut en outre :

un posisteur (9) présentant une valeur d'impédance apte à varier sur la base de la température ; et
un régulateur de tension (7) présentant une broche d'entrée (IN) apte à recevoir une tension d'entrée variable, une broche de sortie (OUT) apte à fournir une tension de sortie modifiable à l'élément chauffant (245) en vue d'ajuster de manière adaptative la chaleur générée par l'élément chauffant (245) sur la base de la tension de sortie modifiable, et une broche d'ajustement (ADJ) fonctionnellement couplée au posisteur (9) en vue de maintenir une tension sensiblement constante au niveau de la broche d'ajustement (ADJ).

13. Procédé selon la revendication 12, consistant en outre à configurer le régulateur de tension (7) et la posisteur (9) de manière à activer l'élément chauffant (245), en vue d'ajuster de manière adaptative la chaleur, lorsqu'une température du synthétiseur de fréquence (205) est inférieure à la température ambiante, à activer l'élément chauffant (245) à moins que la puissance maximale lorsque la température du synthétiseur de fréquence (205) est comprise entre environ la température ambiante et le seuil spécifié, et à désactiver sensiblement l'élément chauffant (245) lorsque la température du synthétiseur de fréquence (205) est sensiblement égale et supérieure au seuil spécifié.

14. Procédé selon la revendication 13, dans lequel le seuil spécifié est d'environ 65 °C.

15. Procédé selon la revendication 9, exploitable de manière à commander un ou plusieurs convertisseurs de fréquence (135) dans l'unité ODU (110).

16. Système radio sans fil (100) selon la revendication 1, dans lequel l'unité ODU (110) inclut :

un convertisseur élévateur de fréquence de transmission (135) destiné à élever en fréquence un signal sortant vers une fréquence de transmission ; et
un convertisseur abaisseur de fréquence de réception (160) destiné à abaisser en fréquence un signal entrant, depuis une fréquence de réception vers une fréquence inférieure ;
dans lequel le module de synthétiseur de fréquence (175) est couplé au convertisseur élévateur de fréquence de transmission (135) et au convertisseur abaisseur de fréquence de réception (160).

17. Système radio sans fil (100) selon la revendication 16, dans lequel une antenne émettrice-réceptrice (150) est couplée à l'unité ODU (110).

18. Système radio sans fil (100) selon la revendication 16, dans lequel le signal entrant et le signal sortant sont des signaux de modulation d'amplitude en quadrature (QAM).

FIG. 1A
(PRIOR ART)

FIG. 1B
(PRIOR ART)

**FIG. 2**

**FIG. 3**

**FIG. 4**

FIG. 5

EP 2 080 413 B1

Total Power Dissipation of Proportional Control Heater Circuit vs. Vin vs. Temperature

FIG. 6

EP 2 080 413 B1

Total Power Dissipation of Proportionally Control Heater Circuit vs. Vin vs. Temperature (-33°C to +35°C)

FIG. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6501340 B

- US 6630869 B